# EUROPÄISCHE PATENTSCHRIFT

(11) **EP 2 758 980 B1**
(45) Veröffentlichungstag und Bekanntmachung des Hinweises auf die Patenterteilung: **15.03.2017**
(21) Anmeldenummer: 12769987.4
(22) Anmeldetag: 12.09.2012
(51) Int. Cl.: H01J 37/26, H01J 37/22

(54) **VERFARHEN ZUR AUSRICHTUNG EINER PHASENPLATTE IN EINEM ELEKTRONENMIKROSKOP**
METHOD AND ALIGNMENT OF A PHASE PLATE IN AN ELECTRON MICROSCOPE
PROCÉDÉ D'ORIENTATION D'UNE PLAQUE DE PHASE DANS UN MICROSCOPE ÉLECTRONIQUE

(30) Priorität: 19.09.2011 DE 102011113645
(43) Veröffentlichungstag der Anmeldung: 30.07.2014
(73) Patentinhaber: Stiftung caesar Center of Advanced European Studies and Research, 53175 Bonn (DE)
(72) Erfinder: IRSEN, Stephan, 53225 Bonn (DE); PATTAI, Steffen, 53489 Sinzig (DE)
(74) Vertreter: Braun-Dullaeus Pannen Patent- und Rechtsanwälte
(86) Internationale Anmeldenummer: PCT/EP2012/067763
(87) Internationale Veröffentlichungsnummer: WO 2013/041413

(56) Entgegenhaltungen:
- EP-A1- 2 333 809
- DE-A1- 10 114 949
- SHIUE J ET AL: "A TEM phase plate loading system with loading monitoring and nano-positioning functions", ULTRAMICROSCOPY, ELSEVIER, AMSTERDAM, NL, Bd. 110, Nr. 9, 1. August 2010 (2010-08-01), Seiten 1238-1242, XP027174565, ISSN: 0304-3991 [gefunden am 2010-05-16]
- MAJOROVITS ET AL: "Optimizing phase contrast in transmission electron microscopy with an electrostatic (Boersch) phase plate", ULTRAMICROSCOPY, ELSEVIER, AMSTERDAM, NL, Bd. 107, Nr. 2-3, 22. Dezember 2006 (2006-12-22), Seiten 213-226, XP005813652, ISSN: 0304-3991, DOI: 10.1016/J.ULTRAMIC.2006.07.006

## Beschreibung

Die Erfindung betrifft ein Verfahren zur Ausrichtung einer Phasenplatte in einem Elektronenmikroskop.

Biologische Proben sind aufgrund Ihrer chemischen Zusammensetzung insbesondere in einem Transmissionselektronenmikroskop fast transparent, d. h. insbesondere, dass sie den Elektronenstrahl nur schwach streuen und daher nur geringen Bildkontrast erzeugen. Eine hauptsächliche Wechselwirkung mit denen die Probe durchdringenden Elektronen besteht in einer Änderung der Phase dieser Elektronen. Phasenänderungen können allerdings nicht direkt sichtbar gemacht werden. Es gibt jedoch die Möglichkeit die Phasenänderung so zu beeinflussen, dass sie sich in einer Kontraständerung im Bild manifestiert. Eine dieser Möglichkeiten stellt das Defokussieren dar. Allerdings gehen dabei Bilddetails verloren. Eine weitere Möglichkeit, eine Phasenänderung zur Verbesserung des Bildkontrasts zu nutzen, bieten Phasenkontrastsysteme. Dazu kann die Phase eines Teils des Elektronenstahls nach dem Durchstrahlen der Probe um einen Betrag von 90 Grad verändert werden. Ein anderer Teil des Elektronenstahls verbleibt unverändert. Beide Teilstrahlen werden anschließend wieder überlagert. Durch die zusätzliche Phasenveränderung entsteht zwischen den vereinigten Teilstrahlen eine Interferenz, die zu einer Kontraststeigerung im Bild führt. Ein solches Phasenkontrastsystem mit einer Phasenplatte ist in der nachveröffentlichten DE 10 2011 014 399 A1 offenbart. Die Schichten dieser Phasenplatte sind mit zumindest einem Loch durchbrochen, durch welches ein Teil des Elektronenstrahls ohne Phasenverschiebung hindurchtreten kann. Andere Teile des Elektronenstrahls erfahren beim Durchtreten der Schichten eine Phasenverschiebung.

In der DE 10 2006 011 615 A1 ist die Funktionsweise eines Phasenkontrast-Transmissionselektronenmikroskops beschrieben. Dieses Elektronenmikroskop hat ein Objektiv mit einer hinteren Brennebene und eine erste Beugungslinse, die die hintere Brennebene des Objektivs vergrößert in eine Beugungszwischenbildebene abbildet. Es ist ferner eine zweite Beugungslinse vorgesehen, deren Hauptebene in der Nähe der Beugungszwischenbildebene angeordnet ist. Ein phasenverschiebendes Element vom Boersch-Typ ist vorgesehen, das in der Nähe oder in der Beugungszwischenbildebene angeordnet ist. Die phasenverschiebende Wirkung wird insbesondere durch die hohe Querschnittsdicke des phasenverschiebenden Elements erreicht. Ein Gitter dient zur Erdung. Um den beschriebenen Phasenkontrast nutzbar zu machen muss die Phasenplatte an einer bestimmten Stelle im Elektronenmikroskop mit einer Genauigkeit von im Bereich von einigen Nanometern positioniert werden und auf dieser justierten Position für den gesamten Zeitraum der Messung mit einer oben beschriebenen Genauigkeit gehalten werden. Typische Messungen mit dem Ziel, die dreidimensionale Struktur z.B. eines Proteins, aufzuklären, benötigen Messzeiten im Bereich von mehreren Stunden, je nach Komplexität der Fragestellung. Während dieser Zeit ist die Phasenplatte aufgrund der Wechselwirkung mit den Elektronen einer Drift unterworfen. Ohne weitere Maßnahmen lassen sich mit eingebauten Phasenplatten derzeit Messzeiten von ca. maximal 30 Minuten erreichen. Danach muss die Phasenplatte nachjustiert werden. Derzeit wird die Positionierung und die Nachjustierung manuell vorgenommen. Dabei wird von einem geübten Bediener eines Elektronenmikroskops das von einer Kamera aufgenommene Bild untersucht. Aufgrund seiner Erfahrung kann er abschätzen, in wie weit eine Phasenplatte von ihrer optimalen Position entfernt ist. Dabei spielt insbesondere ein Schattenwurf der Phasenplatte oder die Projektion des Lochs der Phasenplatte eine Rolle. Das manuelle Nachführen ist aber sehr umständlich und bedarf üblicherweise einer Vielzahl von Versuchsschritten, wobei in jedem der Versuchsschritte mehrere Bilder erzeugt werden, anhand derer der Nutzer prüfen kann, ob die Phasenplatte nun in einer optimalen Position angeordnet ist. Gegebenenfalls werden auch kontinuierlich Bilder, also ein Film, während der Positionseinstellung aufgenommen, was das manuelle Nachführen der Phasenplatte deutlich erleichtert. Durch die Vielzahl der aufgenommenen Bilder während des Positionierens bzw. Nachjustierens wird die zu untersuchende Probe bereits mit großen Menge von Elektronen beaufschlagt. Die Probe, insbesondere eine solche aus biologischem Material, kann dabei bereits unbrauchbar für die nachfolgende Untersuchung werden.

Ein weiteres Phasenkontrast-Elektronenmikroskop und ein Verfahren zur Ausrichtung der Phasenplatte im Elektronenmikroskop ist in der EP 2 333 809 A1 beschrieben.

In "A TEM phase plate loading system with loading monitoring and nano-positioning functions" (Jessie Shiue, Shao-Kang Hung) wird die Verwendung von Nano-Aktuatoren zur Ausrichtung der Phasenplatte beschrieben.

Es ist daher Aufgabe der vorliegenden Erfindung, ein verbessertes Verfahren zur Ausrichtung einer Phasenplatte in einem Elektronenmikroskop bereitzustellen, bei dem die Beaufschlagung der zu untersuchenden und bereits im Elektronenmikroskop eingelegten Probe mit Elektronen möglichst gering ausfällt. Die der Erfindung zugrunde liegende Aufgabe wird gelöst durch ein Verfahren nach Anspruch 1. Bevorzugte Ausgestaltungen ergeben sich aus den Unteransprüchen.

Unter der lateralen Position wird im Wesentlichen die Ausrichtung der Phasenplatte parallel zur Brennebene verstanden. Die Phasenplatte kann durch Verändern der Position der Phasenplatte in einer Richtung parallel zum Elektronenstrahl gegenüber der Brennebene ausgerichtet werden; die Phasenplatte kann aber auch durch Verschieben der Brennebene in einer Richtung parallel zum Elektronenstrahl ausgerichtet werden. Das Ausrichten kann prinzipiell sowohl durch mechanisches Verschieben der Phasenplatte als auch durch kontrolliertes Ablenken des Elektronenstrahls erfolgen, wobei erstgenannte Methode vorzuziehen ist, da eine Änderung des Elektronenstrahls sich negativ auf die Abbildungsqualität auswirken kann.

Der Kern der Erfindung liegt insbesondere darin, dass durch die Verwendung eines automatisierten Bildanalyseverfahrens das manuelle Ausprobieren durch ein zuverlässiges Analyseverfahren ersetzt ist. Die Ausrichtung kann dabei insbesondere auch automatisiert analysiert und nachgeregelt werden. Die Genauigkeit des Ausrichtens kann deutlich erhöht werden. Es wird ermöglicht, dass die Anzahl der aufzunehmenden Bilder deutlich reduziert werden kann. Die Nutzerfreundlichkeit der Bedienung des Elektronenmikroskops kann gesteigert werden. Die Gefahr, die Probe während der Messung zu zerstören, sinkt deutlich.
Dabei wird es insbesondere durch das Verwenden des automatisierten Bildanalyseverfahrens überhaupt erst ermöglicht, dass die Phasenmikroskopie insbesondere in der Kryo-Elektronenmikroskopie auch für weniger versierte Nutzer einsetzbar ist und damit für eine breite Verwendung anwendbar.

Dabei erfolgt ein Einstellen der Linse auf eine erste Brennweite und anschließend Aufnehmen eines ersten Bildes; Einstellen der Linse auf eine zweite Brennweite und anschließend Aufnehmen eines zweiten Bildes. Die erste Brennweite ist unterschiedlich zur zweiten Brennweite und die erste Brennweite und die zweite Brennweite sind ungleich zum optischen Abstand zwischen Linse und Phasenplatte sind. Mit anderen Worten: die Linse wird zum Zeitpunkt des ersten Bildes und des zweiten Bildes unscharf in Bezug auf die Phasenplatte gestellt. Es wird dann das erste Bild und das zweite Bild mittels des Bildanalyseverfahrens ausgewertet, womit dann der Korrekturwert ermittelt wird. Es erfolgt dann ein Verändern der Position der Phasenplatte in Abhängigkeit des Korrekturwertes. Sollte der Korrekturwert entsprechend klein ausfallen, kann auf eine Korrektur gegebenenfalls verzichtet werden. Der Korrekturwert kann eine ermittelte oder berechnete Aktuatorstellgröße sein. Die Probe selbst ist bereits in das Elektronenmikroskop eingelegt und richtig positioniert.

Der Kern dieser Vorgehensweise liegt insbesondere darin, dass aufgrund des bewussten Unscharfstellens Teile der Phasenplatte als Projektion sichtbar werden. Bei scharf gestellter Linse hingegen würde die Phasenplatte exakt in der Brennebene liegen, sodass dann in der Bildebene kein Schattenwurf der Phasenplatte zu erkennen ist. Dabei wird die Erkenntnis zugrunde gelegt, dass der Schattenwurf der Phasenplatte aus dem Bildzentrum heraus wandert, sobald die Phasenplatte nicht exakt zentriert gegenüber dem Elektronenstrahl ausgerichtet ist. Um nun festzustellen, wie weit die Phasenplatte aus dem Zentrum entfernt ist, wird ein zweites Bild aufgenommen, bei dem die Brennweite erneut einen anderen Wert annimmt und die Kondensorlinse weiterhin unscharf gestellt ist. Die Linse ist bezüglich der ersten Einstellung anders unscharf gestellt, also entweder etwas unschärfer oder etwas schärfer als während der Aufnahme des ersten Bildes. Bei gleicher Positionierung der Phasenplatte ändert sich jedoch aufgrund der unterschiedlichen Schärfeeinstellung die Position des Schattenwurfs im zweiten Bild gegenüber der Position des Schattenwurfs im ersten Bild. Das heißt, dass die Position der Schattenwürfe in beiden Bildern unterschiedlich zueinander sind, obwohl die laterale Position der Phasenplatte tatsächlich unverändert bleibt. Die unterschiedliche Position der Schattenwürfe auf beiden Bildern hängt dabei von dem Grad der Defokussierung ab, also vom Grad der Unschärfe der Linse. In Bildanalyseverfahren kann nun die Abweichung in Abhängigkeit der Defokussierung analysiert werden. Hierbei können beispielsweise experimentell bestimmte Kennwerte verwendet werden, die aus den jeweiligen Abweichungen der Verschiebung der Schattenwürfe in Abhängigkeit von beispielsweise Brennweitendifferenzen Rückschlüsse auf die tatsächliche Verschiebung der Phasenplatte gegenüber dem Bildmittelpunkt und damit gegenüber der zentrierten Position im Elektronenstrahl bereitstellen. Die Rückschlüsse auf die Verschiebung können dann zur Erzeugung eines Korrekturwertes herangezogen werden. Ein solcher Korrekturwert kann beispielsweise ein Vektorwert sein, der neben einer betragsmäßigen Abweichung auch noch Angaben über die Richtung der Abweichung umfasst. Anhand dieses Korrekturwertes kann dann eine Korrektur tatsächlich durchgeführt werden, nämlich ein laterales Umpositionieren oder Verschieben der Phasenplatte in einer Richtung und einem Betrag entsprechend dem Korrekturwert.

Dieses Verfahren zeichnet sich insbesondere dadurch aus, dass nur eine sehr geringe Anzahl von Bildern aufgenommen werden muss, um eine relativ hohe Genauigkeit der lateralen Positionsgenauigkeit der Phasenplatte zu erzielen.

Vorzugsweise wird in einem Iterationsschritt die Linse auf die erste Brennweite eingestellt; während dieser Einstellung wird ausschließlich das erste Bild aufgenommen. Während dieses Iterationsschrittes wird die Linse ferner auf die zweite Brennweite eingestellt; während dieser Einstellung wird ausschließlich das zweite Bild aufgenommen. Insgesamt werden während eines solchen Iterationsschrittes vorzugsweise exakt zwei Bilder aufgenommen. Sind die gerätetypischen Korrekturfaktoren einmalig ermittelt worden, können diese zwei Bilder nämlich ausreichen, um eine Korrektur zu ermitteln bzw. um die Verschiebung bei insbesondere bekanntem Grad der Defokussierung ausreichend exakt zu bestimmen. Durch das Aufnehmen von insbesondere ausschließlich zwei Bildern während eines solchen Iterationsschrittes kann die Strahlenbelastung für die Probe so gering wie möglich gehalten werden. Es ist dabei zu berücksichtigen, dass die Positionierung der Phasenplatte erst dann vorgenommen werden kann, wenn die Probe selbst bereits eingelegt und richtig positioniert ist. Ein nachträgliches Einlegen der Probe, nachdem die Phasenplatte bereits korrekt positioniert ist, ist hingegen nicht möglich, da auch die Probe einen Einfluss auf die Magnetfelder im Bereich der Objektivlinse des Mikroskops hat. Diese Beeinflussung führt unter anderem zu einer leichten Verschiebung der optischen Achse des Elektronenstrahls im Bereich der hinteren Brennebene, in der sich die Phasenplatte befindet. Eine Verschiebung der Probe über ein kontrolliertes Ablenken des Elektronenstrahls unterhalb der Phasenplatte ist zwar prinzipiell möglich. Das Maß dieser Ablenkung reicht allerdings nicht aus, um die Probe aus dem Bild zu bewegen. Ein leichtes Verfahren der Probe mit Hilfe des Probengoniometers ist eine weitere Möglichkeit, die Probe zu bewegen, ohne dass die Lage des Elektronenstrahls im Bereich der Phasenplatte zu stark beeinflusst wird. Allerdings ist die Genauigkeit der üblichen Goniometer derzeit nicht ausreichend, um im Bereich von Nanometern an die ursprüngliche Probenposition zurück zu fahren. Das führt dazu, dass zur Feinpositionierung der Probe wieder mehrere Kontrollbilder aufgenommen werden müssen.

Vorzugsweise wird das automatisierte Auswerten des ersten Bildes und des zweiten Bildes mit Hilfe einer Korrelationsfunktion des ersten Bildes mit dem zweiten Bild durchgeführt. Eine solche Korrelationsfunktion kann beispielsweise das Bilden einer Kreuzkorrelation sein. Die Kreuzkorrelation bildet dabei eine einfache Möglichkeit, eine Art Vergleichsbild herzustellen, aus dem Abweichungen erkennbar sind. Die Abweichungen können dann zur Bildung eines Korrekturwertes herangezogen werden.

Vorzugsweise wird nach jedem Verändern der Phasenplatte jeweils ein weiteres erstes und ein weiteres zweites Bild aufgenommen. Diese Bilder werden automatisiert zu einem Korrekturwert ausgewertet. In Abhängigkeit des Korrekturwertes kann dann die Position der Phasenplatte erneut verändert werden.

Vorzugsweise wird jedoch die Position der Phasenplatte lediglich dann verändert, wenn der Korrekturwert einen vorgegebenen Grenzwert überschreitet. Der Grenzwert bildet dabei eine Art Vergleichswert dahingehend, ob die derzeitige Position der Phasenplatte bereits ausreichend ist oder ob die derzeitige Position eben nicht ausreichend für eine nachfolgende Messung ist. Sollte der Korrekturwert den Grenzwert unterschreiten, dann ist eine erneute Veränderung der lateralen Position oder Nachjustierung nicht mehr erforderlich.

Vorzugsweise werden während des lateralen Positioniervorgang maximal vier Bilder aufgenommen. Die ersten zwei Bilder werden bei einem ersten Iterationsschritt zur Ermittlung der Korrekturwerte vorgenommen. Die zweiten zwei Bilder werden zur Überprüfung der veränderten lateralen Position nach der ersten Korrekturschleife verwendet. Das erfindungsgemäße Verfahren zeichnet sich vorzugsweise eben dadurch aus, dass lediglich ein Iterationsschritt zur Überprüfung und Anpassung der lateralen Positionierung vorgenommen wird, welcher dann bereits zu einer ausreichend genauen lateralen Positionierung der Phasenplatte führt. Die zweiten zwei Bilder dienen somit lediglich zur Überprüfung der lateralen Position. In einer weiteren bevorzugten Ausgestaltung kann dann auch noch auf die zweiten zwei Bilder verzichtet werden, wenn davon ausgegangen werden kann, dass die laterale Positioniermethode derart genau ist, dass ein einziger Iterationsschritt mit einer hohen Wahrscheinlichkeit für eine genaue laterale Positionierung ausreicht.

Vorzugsweise wird zum relativen Ausrichten der Phasenplatte gegenüber der Brennebene ein Abbild eines Lochs der Phasenplatte durch eine Bilderkennungseinheit aufgenommen, wobei in einem automatisierten Bildanalyseverfahren mit einem hinterlegten Abbild des Lochs verglichen wird. Es wird dann ein Unschärfewert ermittelt, anhand dessen die relative Ausrichtung zwischen Brennebene und Phasenplatte angepasst wird. Das Anpassen kann dann ein insbesondere vertikales Verändern, d.h. parallel zum Elektronenstrahl, der Lage der Brennebene und/oder ein vertikales Verlagern der Phasenplatte sein.

Vor der eigentlichen Messung wird bevorzugt die exakte Linseneinstellung, insbesondere ein Linsenstrom zur Ansteuerung der Kondensorlinse, ermittelt und abgespeichert. Während der Messung muss dann lediglich überprüft werden, ob die Ausrichtung der Phasenplatte relativ zur Brennebene noch ausreichend genau ist. Dabei können analog zur lateralen Ausrichtung der Phasenplatte Bilder oder Teile der davon ausgewertet werden, die mit der Bildaufnahmeeinheit (z.B. einer CCD-Kamera) aufgenommen wurden.

Vorzugsweise kann zum relativen Ausrichten der Phasenplatte gegenüber der Brennebene ein erstes Abbild des Lochs und ein zweites Abbild des Lochs der Phasenplatte mittels einer Bildaufnahmeeinheit erzeugt werden, wobei das erste Abbild des Lochs und das zweite Abbild des Lochs mittels eines Bildanalyseverfahren miteinander verglichen werden. Hierdurch kann ein Unschärfewert ermittelt werden, wobei anhand des Unschärfewertes die Ausrichtung zwischen Brennebene und Phasenplatte angepasst wird. Insbesondere können die in den Abbildern dargestellten Lochdurchmesser miteinander verglichen werden, wobei aus der Lochdurchmesserdifferenz der Unschärfewert ermittelt wird. Alternativ zu einem von der Bildaufnahmeeinheit erzeugten Abbildes kann auch ein hinterlegtes Abbild des Lochs als Vergleichswert herangezogen werden.

Dabei kann zunächst die Brennweite auf einen beliebigen Wert eingestellt werden. Sollte der Lochdurchmesser in dieser Brennweiteneinstellung nicht erkennbar sein, dann sollte die Brennweite angepasst werden, und zwar in Richtung der vermuteten scharfen Einstellung. Dies kann beispielsweise durch eine Erhöhung oder Verringerung des Linsenstroms zur Ansteuerung der Linse um etwa 10% durchgeführt werden. Dieser Schritt kann mehrfach wiederholt werden, falls erforderlich. Sobald dann das Loch auf einem Bild erkannt wird, kann mit der eigentlichen Feinausrichtung begonnen werden.

Alternativ oder in Kombination kann bei der Ermittlung des Unschärfewertes ein Grad der Rundheit von Abbildern des Lochs berücksichtigt werden. Dies beruht auf der Erkenntnis, dass in Abbildern dargestellte runde Konturen bei zunehmender Unschärfe nicht mehr exakt rund wiedergegeben werden. Die Abbildung des Lochs kann an dessen Kontur unterschiedliche Krümmungen aufweisen. Je geringer die Abweichungen der Krümmungsradien sind, desto höher ist der Grad der Rundheit, da sich die Abbildung dann der Kreisform annähert. Je größer allerdings die Abweichungen der Krümmungsradien sind, desto mehr entfernt sich die Form der Kontur von der Kreisform. Der Grad der Rundheit sinkt.

Der Grad der Rundheit kann anhand der charakteristischen Eingenschaften einer Ellipse ermittelt werden. Wenn die Längen der Hauptachsen gleichlang sind, dann ist das Loch kreisrund. Je größer die Differenzen der Längen der Hauptachsen sind, desto unrunder ist das Abbild des Lochs. Ferner ist der Winkel bedeutend, in dem die Hauptachsen zueinander liegen sowie der Winkel der Hauptachsen gegenüber dem Koordinatensystem: Je schräger die Ellipse im Koordinatensystem liegt, desto unrunder ist das Abbild des Lochs.

Die Erfindung betrifft ferner ein Elektronenmikroskop, umfassend eine Phasenkontrasteinheit nach dem vorherigen Anspruch oder eine Phasenplatte, die durch ein Verfahren der vorgenannten Art innerhalb des Elektronenmikroskops ausgerichtet ist.

Die Erfindung wird nachfolgend anhand der Figuren näher erläutert. Hierin zeigt
- Figur 1: den schematischen Aufbau eines Elektronenmikroskops;
- Figur 2: eine Phasenplatte in Draufsicht;
- Figur 3: Bilder der Phasenplatte bei unterschiedlichen Brennweiten der Kondensorlinse und exakt ausgerichteter Phasenplatte;
- Figur 4: Bilder der Phasenplatte bei unterschiedlichen Brennweiten der Kondensorlinse und nicht exakt ausgerichteter Phasenplatte;
- Figur 5: Abbildung einer Kreuzkorrelation der Bilder nach Figur 4a und Figur 4b.

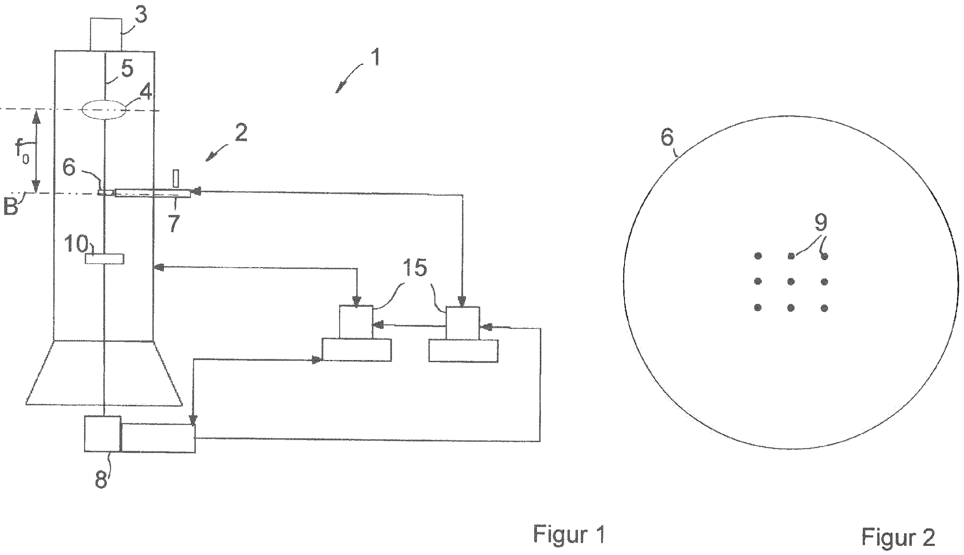

In Figur 1 ist ein Elektronenmikroskop 1 gezeigt, in dem eine Phasenplatte 6 nach dem erfindungsgemäßen Verfahren positioniert werden kann. Das Elektronenmikroskop 1 umfasst eine Elektronenstrahlquelle 3 zur Erzeugung eines Elektronenstrahls 5. Der Elektronenstrahl 5 durchläuft eine Kondensorlinse 4 und anschließend die Phasenplatte 6, die Bestandteil einer Phasenkontrasteinheit 2 ist. Die Phasenkontrasteinheit 2 umfasst neben der Phasenplatte 6 auch eine Phasenplattenhalterung 7 und in der Figur nicht dargestellte Mittel zum Positionieren der Phasenplatte 6. Die Mittel zur Positionierung können Stellaktoren, insbesondere Piezzoaktoren umfassen. Unterhalb der Phasenplatte 6 ist in der Regel eine zu untersuchende Probe 10 angeordnet. Nach Durchdringen der Probe 10 trifft der Elektronenstrahl auf die Kamera 8, welche ein Bild aufnimmt. Ferner sind eine oder mehrere Steuerungseinheiten 15 zur Steuerung des Elektronenmikroskops 1 und der Phasenkontrasteinheit 2 vorgesehen.

In Figur 2 ist eine Phasenplatte 6 gezeigt, die zur Verwendung in einem Elektronenmikroskop 1 nach Figur 1 geeignet ist. Es können aber auch andere Phasenkontrasteinheiten verwendet werden. Die hier verwendete Phasenplatte 6 entspricht weitestgehend einer solchen, wie sie in der mittlerweile veröffentlichten deutsches Patentanmeldung DE 10 2011 014 399 beschrieben ist, und umfasst mehrere Löcher 9. Beim Versuchsbetrieb muss jeweils ein Loch 9 exakt gegenüber dem Elektronenstrahl 5 ausgerichtet sein. Hierzu ist die Phasenplatte 6 entsprechend zu positionieren.

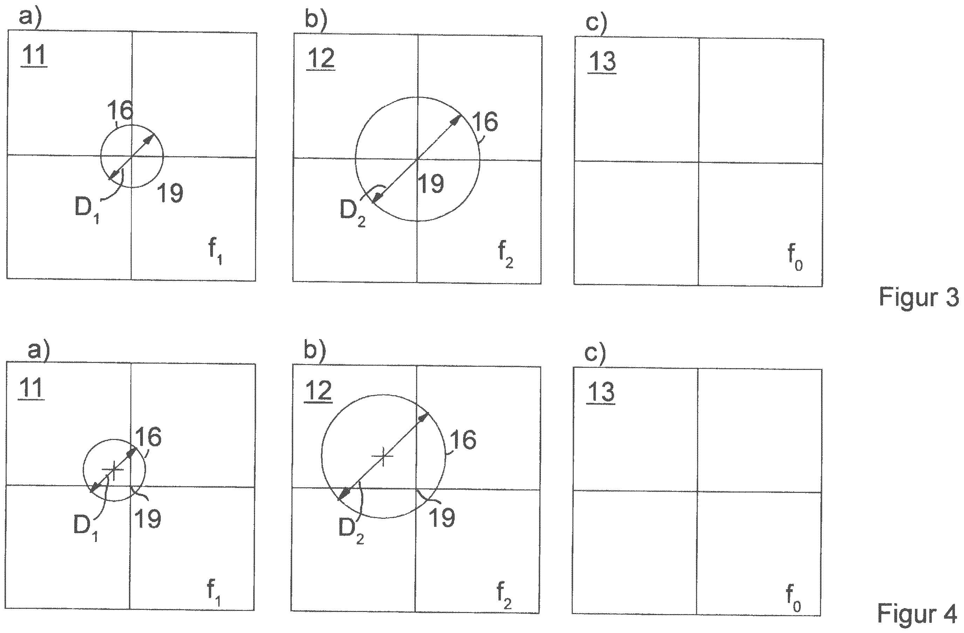

In Figur 3 sind unterschiedliche Bilder gezeigt, die mit der Kamera 8 zu unterschiedlichen Zeitpunkten des Ausrichtverfahrens aufgenommen wurden. Im ersten Bild 11 nach Figur 3a ist dabei ein Schattenwurf 16 gezeigt, der beim Durchstrahlen eines der Löcher 9 entsteht. Der Schattenwurf 16 ist aber nur dann zu erkennen, wenn an der Kondensorlinse 4 eine Brennweite f₁ eingestellt ist, die sich vom Abstand f₀ der Kondensorlinse zur Phasenplatte 6 unterscheidet. Mit anderen Worten: die Kondensorlinse 4 ist bezüglich der Phasenplatte 6 unscharf gestellt, also defokussiert. Im zweiten Bild 12 nach Figur 3b ist ein weiterer Schattenwurf 16 des Lochs 9 gezeigt, der jedoch größer ist als der Schattenwurf 16 nach Figur 3a. Der Größenunterschied ergibt sich aus der unterschiedlichen Brennweiteneinstellung bzw. Fokussierung der Kondensorlinse. Beim Bild nach Figur 3b ist die Brennweite der Kondensorlinse 4 näher an die korrekte Brennweite f₀ eingestellt. Die Kondensorlinse 4 ist also etwas schärfer gestellt bezogen auf die Einstellung nach Figur 3a. In Figur 3c ist ein drittes Bild 13 gezeigt, in dem kein Schattenwurf mehr zu erkennen ist. Die Einstellungen der Kondensorlinse 4 ist dabei derart, dass die Brennweiteneinstellung f₃ dem Abstand f₀ der Kondensorlinse 4 zur Phasenplatte 6 entspricht. Die Kondensorlinse 4 ist also scharf gestellt. Der Schattenwurf 16 ist dabei sehr weit nach außen gewandert und damit nicht mehr im dritten Bild zu erkennen.

Die Darstellungen nach Figur 3 haben jedoch gemein, dass das Zentrum des Schattenwurfs jeweils übereinstimmt mit dem Bildzentrum 19. Das Bildzentrum 19 stimmt ferner überein mit dem Zentrum des Elektronenstrahls 5. Folglich ist der Schattenwurf 16 und damit die Phasenplatte 6 in Figur 3 korrekt zum Elektronenstrahl 5 ausgerichtet. Die Erkenntnis besteht nun zunächst darin, dass erst bei defokussierter Kondensorlinse 4 der Schattenwurf sichtbar wird und damit Rückschlüsse auf eine laterale Position der Phasenplatte 6 visuell möglich werden.

In Figur 4 sind nun weitere Bilder 11, 12, 13 gezeigt, wobei die Brennweiteneinstellungen f₁, f₂, f₃ den Bildern nach Figur 3 entsprechen. Die Abweichung zu den Bildern nach zur Figur 3 liegt aber darin, dass das Loch der Phasenplatte 6 nun nicht korrekt ausgerichtet ist bzw. nicht mehr zentriert gegenüber dem Elektronenstrahl 5 ist. In Figur 4c ist ebenso wie in Figur 3c kein Schattenwurf zu erkennen, was bei scharf gestelltem Fokus der Kondensorlinse nicht möglich ist. In Figur 4a ist wiederum ein gezieltes Defokussieren mit der Brennweiteneinstellung f₁ vorgenommen worden, wodurch der Schattenwurf 16 erkennbar wird. Es ist aber ersichtlich, dass das Zentrum des Schattenwurfs 16 exzentrisch zum Bildzentrum 19 ist. Die Phasenplatte 6 ist daher lateral nicht korrekt positioniert. In Figur 4b ist die zweite Brennweite f₂ eingestellt, wodurch ein größerer Schattenwurf 16 erzeugt wird. Im Gegensatz zum Bild nach Figur 4a ist aber auch das Zentrum des Schattenwurfs weiter nach außen gerückt, obwohl die Phasenplatte 6 bezogen auf das erste Bild 11 nach Figur 4a nicht bewegt wurde. Dies liegt daran, dass bei zwar gleichbleibender lateraler Position die Schattenwürfe 16 je nach unterschiedlichen Brennweiteneinstellungen andere Positionen einnehmen, wenn die Phasenplatte nicht korrekt positioniert ist. Mit anderen Worten: der Schattenwurf eines nicht exakt positionierten Lochs 9 der Phasenplatte 6 befindet sich im Bild desto weiter außen, je schärfer die Kondensorlinse 4 eingestellt ist.

Die relative Abweichung der Zentren der Schattenwürfe 16 bei jeweils bekannter Brennweiteneinstellung stellt damit ein Maß für die tatsächliche Fehlpositionierung der Phasenplatte gegenüber dem Elektronenstrahl dar.

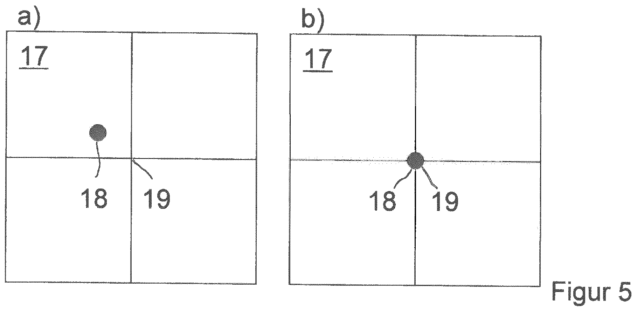

Um nun die Exzentrizität des Lochs 9 der Phasenplatte 6 gegenüber dem Elektronenstrahl 5 zu ermitteln werden die Bilder 11, 12 nach Figur 4 a) und b) einer Korrelation, insbesondere einer Kreuzkorrelation, unterzogen. Das Ergebnis einer solchen Kreuzkorrelation ist das in Figur 5a gezeigte Korrelationsbild 17, welches ein Zentrum 18 aufweist. Die räumliche Abweichung des Zentrums 18 vom Bildzentrum 19 stellt bildlich die Fehlpositionierung der Phasenplatte gegenüber dem Elektronenstrahl 5 dar. Durch Bildauswertung kann ein Korrekturvektor K ermittelt werden, der z.B. die geometrische Abweichung des Zentrums des Korrelationsbilds 17 gegenüber dem Bildzentrum 19 ausdrückt. Mit diesem Korrekturvektor K können dann die Mittel zur Positionierung der Phasenplatte 6 angesteuert werden, wodurch die laterale Position der Phasenplatte 6 innerhalb des Elektronenmikroskops 1 bzw. gegenüber dem Elektronenstrahl 5 verändert werden kann.

In Anschluss an die Korrektur der Position kann das beschriebene Verfahren erneut durchgeführt werden, um zu überprüfen, ob die Position der Phasenplatte nunmehr ausreichend exakt ist für die nachfolgende Untersuchung einer Probe. In Figur 5b ist dann beispielhaft gezeigt, dass das Zentrum 18 des aus der weiteren Überprüfung resultierende Kreuzkorrelationsbildes 17 im wesentlichen korrekt ausgerichtet ist zum Bildzentrum 19. Die Phasenplatte 6 ist damit korrekt ausgerichtet.

Die Erkenntnis, dass bei unterschiedlichen Schärfeeinstellungen, d.h. bei unterschiedlichen Defokussierungen, der Schattenwurf des Lochs unterschiedlich erscheint, kann auch zur Fokussierung der Kondensorlinse herangezogen werden. Wie in den Figuren 3a, 3b, 4a und 4b zu erkennen ist, sind die Schattenwürfe 16 des Lochs 9 unterschiedlich groß und zwar in Abhängigkeit des Grades der Scharfstellung. Während in den Figuren 3a und 4a die Linse sehr unscharf gestellt ist, ist die Linse in den Figuren 3b und 4b näher an die Scharfstellung angelehnt, also nicht mehr so sehr unscharf wie in den Figuren 3a und 4a. Es ist anhand der erscheinenden Durchmesser D₁, D₂ der Löcher ersichtlich, dass die Schattenwürfe 16 bei Schärferstellung größer werden. Ein Vergleich der beiden Abbildungen nach Figuren 3a, 3b bzw. 4a, 4b kann dann dazu führen, dass aus den ermittelten Größenverhältnissen die Unschärfe in den jeweiligen Bildern erkannt wird. Dann ist die Linse lediglich durch entsprechende Vergrößerung oder Verkleinerung des Linsenstroms anzupassen.

Entsprechende Werte zur Anpassung der Linse können tabellarisch hinterlegt sein. Dabei ist es nicht erforderlich, dass zwei Bilder erzeugt werden; vielmehr ist es auch möglich, dass ein bereits hinterlegtes Bild für den Vergleich verwendet wird. Bei dem hinterlegten Bild kann der Grad der Unschärfe sowie die Größe des Schattenwurfs bzw. der Durchmesser des Schattenwurfs erkennbar sein. Der Schattenwurf stellt dabei das Abbild des Lochs der Phasenplatte dar.

Weitere Verfeinerungen können dadurch vorgenommen werden, dass neben oder anstatt den Lochdurchmessern D der Schattenwürfe 16 auch die Rundheit der Schattenwürfe 16 begutachtet wird. Je schärfer die Linse gestellt ist, desto mehr nähert sich der Schattenwurf 16 der Form eines Kreises an. Bei unscharf gestellten Linsen kann es hingegen auch zu einer Art Ellipsenbildung oder anderen Verzerrungen des Schattenwurfs 16 kommen. Aus Parametern der Ellipse, wie beispielsweise der Größe der Halbachsen, kann dann auf die Unschärfe geschlossen werden. Anhand der festgestellten Unschärfe kann dann ein Parameter zum Einstellen der Fokussierung erzeugt werden.

### Bezugszeichenliste

- 1: Elektronenmikroskop
- 2: Phasenkontrasteinheit
- 3: Elektronenstrahlquelle
- 4: Kondensorlinse
- 5: Elektronenstrahl
- 6: Phasenplatte
- 7: Phasenplattenhalterung
- 8: Bildaufnahmeeinheit
- 9: Loch
- 10: Probe
- 11: erstes Bild
- 12: zweites Bild
- 13: drittes Bild
- 15: Steuerungseinheiten
- 16: Schattenwurf
- 17: Kreuzkorrelationsbild
- 18: Zentrum
- 19: Bildzentrum

- f: Brennweite
- f₀: Abstand der Kondensorlinse zur Phasenplatte
- f₁: erste Brennweite
- f₂: zweite Brennweite
- f₃: dritte Brennweite
- K: Korrekturwert
- D: Lochabbilddurchmesser

## Patentansprüche

1. Verfahren zum Ausrichten einer Phasenplatte (6) innerhalb eines Elektronenmikroskops (1),
wobei das Elektronenmikroskop (1) eine Elektronenstrahlquelle (3) zur Erzeugung eines Elektronenstrahls (5), zumindest eine Linse (4) zur Fokussierung des Elektronenstrahls (5) und eine Bildaufnahmeeinheit (8) zur Erzeugung eines Bildes durch Erfassung des Elektronenstrahls (8) aufweist, wobei mittels der Phasenplatte (6) Teilen des Elektronenstrahls (5) eine definierte Phasenverschiebung zugefügt wird,
umfassend die folgenden Verfahrensschritte:
relatives Ausrichten der Phasenplatte (6) gegenüber einer Brennebene (B) der Linse (4), laterales Positionieren der Phasenplatte (6) innerhalb der Brennebene (B), nachdem die zu untersuchende Probe bereits in das Elektronenmikroskop (1) eingelegt und darin positioniert ist,
wobei zumindest ein Bild mittels der Bildaufnahmeeinheit (8) aufgenommen wird und mittels eines automatisierten Bildanalyseverfahrens ein Korrekturwert (K) ermittelt wird,
Verändern der lateralen Position der Phasenplatte (6) in Abhängigkeit des Korrekturwertes (K),
**dadurch gekennzeichnet,**
**dass** zur Ermittlung des Korrekturwertes (K) folgende Verfahrensschritte durchgeführt werden:
Einstellen der Linse (4) auf eine erste Brennweite (f₁) und anschließend Aufnehmen eines ersten Bildes (11),
Einstellen der Linse (4) auf eine zweite Brennweite (f₂) und anschließend Aufnehmen eines zweiten Bildes (13),
wobei die erste Brennweite (f₁) unterschiedlich zur zweiten Brennweite (f₂) ist und die erste Brennweite (f₁) und die zweite Brennweite (f₂) ungleich zum optischen Abstand (f₀) zwischen Linse (4) und Phasenplatte (6) sind,
automatisiertes Auswerten des ersten Bildes (11) und des zweiten Bildes (12) mittels des Bildanalyseverfahrens und Ermitteln des Korrekturwertes (K).

2. Verfahren nach Anspruch 1, **dadurch gekennzeichnet, dass** in einem Iterationsschritt die Linse auf die erste Brennweite (f₁) eingestellt und während dieser Einstellung ausschließlich das erste Bild (11) aufgenommen wird, und ferner die Linse (4) auf die zweite Brennweite (f₂) eingestellt wird und während dieser Einstellung ausschließlich das zweite Bild (12) aufgenommen wird, wobei innerhalb dieses Iterationsschrittes exakt zwei Bilder (11, 12) aufgenommen werden.

3. Verfahren nach einem der vorherigen Ansprüche, **dadurch gekennzeichnet, dass** eine Veränderung der lateralen Position der Phasenplatte (6) lediglich dann vorgenommen wird, falls der Korrekturwert (K) einen vorgegebenen Grenzwert überschreitet.

4. Verfahren nach einem der vorherigen Ansprüche, **dadurch gekennzeichnet, dass** das automatisierte Auswerten des ersten Bildes (11) und des zweiten Bildes (12) mithilfe einer Korrelationsfunktion, insbesondere einer Kreuzkorrelation, des ersten Bildes (11) mit dem zweiten Bild (12) erfolgt.

5. Verfahren nach einem der vorherigen Ansprüche, **dadurch gekennzeichnet, dass** nach dem jedem Verändern der lateralen Position der Phasenplatte (6) erneut ein erstes und ein zweites Bild (11, 12) aufgenommen wird und diese Bilder automatisiert zu einem Korrekturwert (K) ausgewertet werden und in Abhängigkeit des Korrekturwertes (K) die Position der Phasenplatte (6) verändert wird.

6. Verfahren nach einem der vorherigen Ansprüche, **dadurch gekennzeichnet, dass** während des gesamten lateralen Positioniervorgangs maximal vier Bilder aufgenommen werden.

7. Verfahren nach einem der vorherigen Ansprüche, **dadurch gekennzeichnet, dass** zum relativen Ausrichten der Phasenplatte (6) gegenüber der Brennebene (B) ein Abbild (16) eines Lochs (9) der Phasenplatte (6) durch eine Bilderkennungseinheit aufgenommen wird, wobei das Abbild (16) in einem automatisierten Bildanalyseverfahren mit einem hinterlegten Abbild des Lochs (9) verglichen wird, wodurch ein Unschärfewert ermittelt wird.

8. Verfahren nach einem der vorherigen Ansprüche, **dadurch gekennzeichnet, dass** zum relativen Ausrichten der Phasenplatte (6) gegenüber der Brennebene (B) ein erstes Abbild (11) des Lochs (9) und ein zweites Abbild (12) des Lochs (9) mittels einer Bildaufnahmeeinheit (8) erzeugt wird, wobei das erste Abbild (11) des Lochs (9) und das zweite Abbild (12) des Lochs (9) mittels eines Bildanalyseverfahren miteinander verglichen werden, wodurch ein Unschärfewert ermittelt wird.

9. Verfahren nach einem der Ansprüche 7 oder 8, **dadurch gekennzeichnet, dass** die in den Abbildern (16) dargestellten Lochdurchmesser (D₁, D₂) miteinander verglichen werden, wobei aus einer ermittelten Lochdurchmesserdifferenz der Unschärfewert ermittelt wird.

10. Verfahren nach einem der Ansprüche 7 bis 10 **dadurch gekennzeichnet, dass** bei der Ermittlung des Unschärfewertes ein Grad der Rundheit von Abbildern (16) des Lochs (9) berücksichtigt wird.

11. Verwendung einer Phasenkontrasteinheit (2) für ein Elektronenmikroskop oder Verwendung eines Elektronenmikroskop umfassend eine Phasenkontrasteinheit, die Phasenkontrasteinheit umfasst eine Phasenplatte (6) und Mittel zum Einstellen der Position der Phasenplatte (6) innerhalb eines Elektronenmikroskops (1), zur Durchführung des Verfahrens nach einem der vorherigen Ansprüche.

## Claims

1. A method for aligning a phase plate (6) within an electron microscope (1), wherein
the electron microscope (1) has an electron beam source (3) for purposes of generating an electron beam (5), at least one lens (4) for purposes of focusing the electron beam (5), and an image-recording unit (8) for purposes of generating an image by detection of the electron beam (5), wherein
by means of the phase plate (6) a defined phase displacement is added to parts of the electron beam (5),
comprising the following steps in the method:
relative alignment of the phase plate (6) with respect to a focal plane (B) of the lens (4),
lateral positioning of the phase plate (6) within the focal plane (B), after the specimen to be investigated has already been inserted into the electron microscope (1) and positioned in the latter, wherein
at least one image is recorded by means of the image-recording unit (8), and a correction value (K) is determined by means of an automated image-analysis method,
alteration of the lateral position of the phase plate (6) as a function of the correction value (K), **characterised in that**,
for purposes of determining the correction value (K) the following steps in the method are executed:
adjustment of the lens (4) to a first focal length (f₁) and the subsequent recording of a first image (11),
adjustment of the lens (4) to a second focal length (f₂) and the subsequent recording of a second image (13), wherein
the first focal length (f₁) differs from the second focal length (f₂), and the first focal length (f₁) and the second focal length (f₂) are not equal to the optical distance (f₀) between lens (4) and phase plate (6),
automated evaluation of the first image (11) and the second image (12) by means of the image-analysis method, and determination of the correction value (K).

2. The method in accordance with claim 1,
**characterised in that**,
in an iteration step the lens is adjusted to the first focal length (f₁) and during this adjustment only the first image (11) is recorded, and the lens (4) is furthermore adjusted to the second focal length (f₂) and during this adjustment only the second image (12) is recorded, wherein
within this iteration step precisely two images (11, 12) are recorded.

3. The method in accordance with one of the preceding claims,
**characterised in that**,
an alteration of the lateral position of the phase plate (6) is then undertaken only if the correction value (K) exceeds a prescribed threshold value.

4. The method in accordance with one of the preceding claims,
**characterised in that**,
the automated evaluation of the first image (11) and the second image (12) is undertaken with the aid of a correlation function, in particular a cross correlation of the first image (11) with the second image (12).

5. The method in accordance with one of the preceding claims,
**characterised in that**,
after each alteration of the lateral position of the phase plate (6) a first and a second image (11, 12) are again recorded, and these images are evaluated in an automated manner to form a correction value (K), and the position of the phase plate (6) is altered as a function of the correction value (K).

6. The method in accordance with one of the preceding claims,
**characterised in that**,
during the whole of the lateral positioning process a maximum of four images are recorded.

7. The method in accordance with one of the preceding claims,
**characterised in that**,
for purposes of relative alignment of the phase plate (6) with respect to the focal plane (B) an image (16) of a hole (9) of the phase plate (6) is recorded by an image-recognition unit, wherein
the image (16) is compared with a stored image of the hole (9) in an automated image-analysis method, whereby a blur value is determined.

8. The method in accordance with one of the preceding claims,
**characterised in that**,
for purposes of relative alignment of the phase plate (6) with respect to the focal plane (B) a first image (11) of the hole (9) and a second image (12) of the hole (9) are generated by means of an image-recording unit, wherein
the first image (11) of the hole (9) and the second image (12) of the hole (9) are compared with one another by means of an image-analysis method, whereby a blur value is determined.

9. The method in accordance with one of the claims 7 or 8,
**characterised in that**,
the hole diameters (D₁, D₂) represented in the images (16) are compared with one another, wherein
the blur value is determined from a difference determined between the hole diameters.

10. The method in accordance with one of the claims 7 to 10,
**characterised in that**,
in the course of determining the blur value a degree of roundness of images (16) of the hole (9) is taken into account.

11. The utilisation of a phase contrast unit (2) for an electron microscope, or the utilisation of an electron microscope comprising a phase contrast unit, the phase contrast unit comprising a phase plate (6) and means for adjusting the position of the phase plate (6) within an electron microscope (1), for purposes of executing the method in accordance with one of the preceding claims.

## Revendications

1. Procédé d'alignement d'une lame de phase (6) à l'intérieur d'un microscope électronique (1), dans lequel le microscope électronique (1) présente une source de faisceau d'électrons (3) pour générer un faisceau d'électrons (5), au moins une lentille (4) pour focaliser le faisceau d'électrons (5) et une unité de capture d'image (8) pour générer une image en détectant le faisceau d'électrons (8), dans lequel au moyen de la lame de phase (6) un déphasage défini est ajouté à des parties du faisceau d'électrons (5), comprenant les étapes de procédé suivantes consistant à :
aligner relativement la lame de phase(6) par rapport à un plan focal (B) de la lentille (4),
positionner latéralement la lame de phase (6) à l'intérieur du plan focal (B), après que l'échantillon à analyser a déjà été placé et positionné dans le microscope électronique (1),
dans lequel au moins une image est capturée au moyen de l'unité de capture d'image (8) et une valeur de correction (K) est déterminée au moyen d'un procédé d'analyse d'image automatisé,
déterminer la position latérale de la lame de phase (6) en fonction de la valeur de correction (K), **caractérisé en ce que**
pour déterminer la valeur de correction (K) les étapes de procédé suivantes sont exécutées consistant à:
régler la lentille (4) sur une première distance focale (f₁) et capturer ensuite une première image (11),
régler la lentille (4) sur une deuxième distance focale (f₂) et capturer ensuite une deuxième image (13),
dans lequel la première distance focale (f₁) est différente de la deuxième distance focale (f₂) et la première distance focale (f₁) et la deuxième distance focale (f₂) sont inégales par rapport à l'écart optique (f₀) entre la lentille (4) et la lame de phase (6),
évaluer de manière automatisée la première image (11) et la deuxième image (12) au moyen du procédé d'analyse d'image et déterminer la valeur de correction (K).

2. Procédé selon la revendication 1, **caractérisé en ce**
**que** dans une étape d'itération la lentille est réglée sur la première distance focale (f₁) et pendant ce réglage exclusivement la première image (11) est capturée, et en outre la lentille (4) est réglée sur la deuxième distance focale (f₂) et pendant ce réglage exclusivement la deuxième image (12) est capturée, dans lequel exactement deux images (11,12) sont capturées pendant cette étape d'itération.

3. Procédé selon une des revendications précédentes,
**caractérisé en ce que** une modification de la position latérale de la lame de phase (6) peut être entreprise uniquement au cas où la valeur de correction (K) dépasse une valeur limite prescrite.

4. Procédé selon une des revendications précédentes,
**caractérisé en ce que** l'évaluation automatisée de la première image (11) et de la deuxième image (12) a lieu à l'aide d'une fonction de corrélation, notamment d'une corrélation croisée, de la première image (11) avec la deuxième image (12).

5. Procédé selon une des revendications précédentes,
**caractérisé en ce que** après chaque modification de la position latérale de la plaque de phase (6) une première et une deuxième image (11,12) est de nouveau capturée et cette image est évaluée de manière automatisée par rapport à une valeur de correction (K) et en fonction de la valeur de correction (K), la position de la lame de phase (6) est modifiée.

6. Procédé selon une des revendications précédentes,
**caractérisé en ce que** prendre la totalité du processus de positionnement latérale, quatre images au maximum sont capturées.

7. Procédé selon une des revendications précédentes,
**caractérisé en ce que** pour l'alignement relatif de la lame de phase (6) par rapport à un plan focal (B) une image (16) d'un trou (9) de la lame de phase (6) est capturée par une unité de reconnaissance d'images, dans lequel l'image (16) est comparée dans le cadre d'un procédé d'analyse d'image avec une image déposée du trou (9), moyennant quoi une valeur de flou est déterminée.

8. Procédé selon une des revendications précédentes,
**caractérisé en ce que** pour l'alignement relatif de la lame de phase (6) par rapport à un plan focal (B) une première image (11) du trou (9) et une deuxième image (12) du trou (9) est générée au moyen d'une unité de capture d'image (8), dans lequel la première image (11) du trou (9) et la deuxième image (12) du trou (9) sont comparées l'une avec l'autre au moyen d'une procédé d'analyse d'image, moyennant quoi une valeur de flou est déterminée.

9. Procédé selon une des revendications 7 ou 8,
**caractérisé en ce que** les diamètres de trous (D1,D2) représentés dans les images (16) sont comparés les uns aux autres, dans lequel la valeur de flou est déterminée d'après une différence de diamètre d trou déterminée.

10. Procédé selon une des revendications 7 à 10,
**caractérisé en ce que** lors de la détermination de la valeur de flou un degré de circularité des images (16) du trou (9) est pris en compte.

11. Utilisation d'une unité de contraste de phase (2) pour
un microscope électronique ou utilisation d'un microscope électronique comprenant une unité de contraste de phase, l'unité de contraste de phase comprend une lame de phase (6) et des moyens de réglage de la position de la lame de phase (6) à l'intérieur d'un microscope électronique (1), pour mettre en oeuvre le procédé selon une des revendications précédentes.
